# FASCICULE DE BREVET EUROPEEN

(11) **EP 3 617 813 B1**
(45) Date de publication et mention de la délivrance du brevet: **26.02.2025**
(21) Numéro de dépôt: 18192184.2
(22) Date de dépôt: 03.09.2018
(51) Int. Cl.: G04D 1/00, B81C 3/00, B65G 11/02, B65G 11/20, H05K 13/02

(54) **DISPOSITIF DE TRANSFERT DE COMPOSANTS HORLOGERS**
TRANSFERVORRICHTUNG FÜR UHRWERKSKOMPONENTEN
DEVICE FOR TRANSFERRING TIMEPIECE COMPONENTS

(43) Date de publication de la demande: 04.03.2020
(73) Titulaire: ROLEX SA, 1211 Genève 26 (CH)
(72) Inventeur: Beaufils, Yann, 74240 Gaillard (FR); Noel, Adrien, 74380 Bonne (FR)
(74) Mandataire: Moinas & Savoye SARL

(56) Documents cités:
- DE-C- 893 744
- GB-A- 2 258 861
- JP-A- S5 123 958
- US-A- 3 426 883
- US-A- 3 490 134
- US-A- 3 661 298
- US-A1- 2008 023 435
- US-A1- 2015 259 143

## Description

### Domaine technique de l'invention

La présente invention concerne un dispositif de transfert de composants horlogers d'un premier conditionnement ou support vers un deuxième conditionnement ou support, le dispositif de transfert étant utilisé lors d'un procédé de fabrication en horlogerie. L'invention se rapporte également à un ensemble de dispositifs de transfert assemblés en série. L'invention se rapporte également à un procédé de fabrication d'un tel dispositif de transfert de composants horlogers ainsi qu'à un procédé de manutention de composants horlogers.

### État de la technique

Dans le domaine de l'horlogerie, il est connu de positionner des composants horlogers, comme par exemple des maillons de bracelet ou des ébauches, dans des conditionnements ou sur des supports afin de procéder à des étapes de fabrication, comme par exemple des étapes d'usinage, de polissage, de dépôt galvanique, de nettoyage, et/ou afin de transférer les composants horlogers entre les différents postes de mise en œuvre d'un procédé de fabrication. Selon les étapes, les conditionnements ou les supports ont des formes et des arrangements de composants horlogers différents pour s'adapter au poste de préparation correspondant, par exemple pour s'adapter au type de manipulation ou au type de machine-outil utilisée par la fabrication. Les différentes machines-outils ont des contraintes spécifiques nécessitant un positionnement particulier des composants horlogers, voire une orientation particulière de ces derniers. Ces composants horlogers peuvent être positionnés dans des conditionnements ou sur des supports spécifiquement adaptés à une machine-outil donnée. Il n'est en général pas possible de conserver le même conditionnement pour les différentes machines-outils mises en œuvre au sein d'un procédé de fabrication et il est souvent nécessaire de reconditionner les composants horlogers pour que le conditionnement soit adapté aux contraintes spécifiques d'une machine-outil donnée.

Les composants horlogers sont en général transférés manuellement d'un conditionnement à l'autre afin de préserver l'intégrité de leurs surfaces, notamment des surfaces fonctionnelles ou des décors des composants horlogers.

Le transfert manuel requiert des étapes de préhension, de manipulation et de posage de chacun des composants horlogers. Les composants horlogers doivent être manipulés avec un soin tout particulier lors des opérations de fabrication. En effet, d'une part les composants horlogers sont fragiles et leur aspect doit être exempt de toute imperfection comme un choc, une rayure ou une salissure. D'autre part, les composants horlogers sont petits ce qui rend leur manipulation particulièrement délicate : les composants horlogers peuvent ainsi facilement s'échapper des mains d'un opérateur et/ou sont difficiles à manipuler. Par ailleurs, les composants horlogers doivent être positionnés aux différents postes de travail avec suffisamment de précision pour que les opérations de fabrication soient correctement exécutées.

Le transfert manuel des composants horlogers est donc un procédé peu rapide et peu ergonomique. Le soin nécessaire pour positionner les composants horlogers avec précision et sans les endommager est généralement antinomique à la vitesse d'exécution de ce positionnement.

US3490134 et US2015259143 représentent des documents pertinents de l'état de la technique.

### Objet de l'invention

Le but de l'invention est de fournir un système de manutention selon la revendication 1, et des procédés de manutention de composants horlogers selon les revendications 14 et 15 remédiant aux inconvénients ci-dessus et améliorant les procédés de manutention de composants horlogers connus de l'art antérieur.

Un premier objet de l'invention est de fournir un dispositif permettant de transférer efficacement lesdits composants horlogers d'un premier conditionnement ou support vers un deuxième conditionnement ou support tout en assurant une protection des composants horlogers durant le transfert.

L'invention se rapporte à un dispositif de transfert de plusieurs composants horlogers agencés sur un premier support vers leur agencement sur un deuxième support, le dispositif de transfert comprenant une face d'entrée comprenant des orifices d'entrée agencés pour correspondre à un premier agencement des composants horlogers sur un premier support, une face de sortie comprenant des orifices de sortie agencés pour correspondre à un deuxième agencement des composants horlogers sur un deuxième support, et des éléments de guidage aptes à guider automatiquement les composants horlogers depuis les orifices d'entrée vers les orifices de sortie.

Les éléments de guidage peuvent se présenter sous la forme de canaux reliant chacun respectivement un orifice d'entrée positionné sur la face d'entrée à un orifice de sortie positionné sur la face de sortie, au moins un élément de guidage induisant le glissement d'un composant horloger sur une paroi dudit au moins un élément de guidage depuis un orifice d'entrée jusqu'à un orifice de sortie.

Au moins un élément de guidage peut comprendre tout ou partie des caractéristiques suivantes :
- une surface de guidage courbe ; et/ou
- une surface de guidage comprenant au moins une chicane ; et/ou
- une surface de guidage apte à induire le déplacement d'un composant horloger selon une translation et/ou selon une rotation ; et/ou
- une surface de guidage apte à induire une modification ou non de l'orientation d'un composant horloger ; et/ou
- une surface de guidage apte à induire une modification de l'orientation d'un composant horloger de sorte que sa surface de contact avec le premier support soit différente de sa surface de contact avec le deuxième support.

Le dispositif de transfert de composants horlogers peut être en polymère ou revêtu au moins partiellement d'une surface en polymère, ou en céramique, ou en métal, notamment en alliage de métaux, pour éviter de choquer les composants horlogers.

Le dispositif de transfert de composants horlogers peut comprendre une grille amovible comprenant des orifices de grille agencés de manière identique ou compatible aux orifices d'entrée de la face d'entrée pour pouvoir être superposés à ces orifices d'entrée de la face d'entrée et permettre le passage de composants horlogers successivement au travers des orifices de grille et des orifices d'entrée.

La grille et la face d'entrée peuvent comprendre un moyen d'indexation pour le bon positionnement de la grille relativement à la face d'entrée.

Le dispositif de transfert de composants horlogers peut comprendre une plaque disposée de manière amovible entre la face d'entrée du premier dispositif de transfert et la grille pour permettre un maintien temporaire de composants horlogers sur la face d'entrée avant leur transfert au travers des orifices d'entrée après retrait ou déplacement de la plaque.

La plaque peut comprendre des ouvertures selon un agencement identique ou compatible avec les orifices d'entrée de la face d'entrée, et la plaque peut être mobile relativement à la face d'entrée, de sorte à pouvoir occuper deux positions, une première position dans laquelle ses ouvertures ne sont pas totalement superposées avec les orifices d'entrée de la face d'entrée de sorte que des composants horlogers sont aptes à rester maintenus au-dessus de la face d'entrée, et une deuxième position dans laquelle ses ouvertures sont superposées avec des orifices d'entrée de la face d'entrée de sorte que des composants horlogers sont aptes à être transférés au travers des ouvertures de la plaque et des orifices d'entrée de la face d'entrée.

Le dispositif de transfert de composants horlogers peut être apte au transfert d'ébauches d'un mouvement horloger comme des platines ou des ponts, des mobiles du mouvement horloger comme des mobiles d'échappement, ou encore des composants horlogers d'habillage, comme des maillons de bracelet ou des plaques de cadran ou des index de cadran.

Le dispositif de transfert de composants horlogers peut être apte à être monté en série avec au moins un deuxième dispositif de transfert tel que défini précédemment. Il peut comprendre des moyens d'indexation et/ou de maintien d'un deuxième dispositif de transfert, au niveau de sa face d'entrée et/ou au niveau d'une face de sortie.

L'invention se rapporte également à un ensemble d'au moins deux dispositifs de transfert de composants horlogers tels que définis précédemment, disposés en série, de sorte que les éléments de guidage respectifs des au moins deux dispositifs de transfert sont reliés pour former des éléments de guidage continus sur l'ensemble des au moins deux dispositifs de transfert.

L'invention se rapporte également à un procédé de fabrication d'un dispositif de transfert de composants horlogers tel que défini précédemment, le procédé de fabrication comprenant une étape de fabrication par addition de matière, notamment selon l'une des technologies suivantes :
i. le modelage par dépôt de matière en fusion ; ou
ii. la polymérisation ou réticulation par couche d'un polymère, notamment la stéreolithographie ; ou
iii. le collage de film avec un adhésif (LOM pour Laminated Object Manufacturing) ; ou
iv. l'agglomération d'une couche de poudre par frittage laser SLS (frittage sélectif par laser) ; ou
v. la fusion de poudre à l'aide d'un laser (SLM pour selective laser melting).

L'invention se rapporte également à un système de manutention de composants horlogers comprenant un premier support comprenant des premiers logements pour le transport et/ou la mise en œuvre d'au moins une première opération sur les composants horlogers, un deuxième support distinct comprenant des deuxièmes logements pour le transport et/ou la mise en œuvre d'au moins une deuxième opération sur les mêmes composants horlogers, et un dispositif de transfert tel que défini précédemment et/ou un ensemble de dispositifs de transfert tel que défini précédemment pour transférer les composants horlogers depuis les premiers logements du premier support vers les deuxièmes logements du deuxième support.

Le premier support peut être un plateau ou une navette et/ou le deuxième support peut être un plateau ou une navette ou une cuve, en particulier une cuve remplie de liquide ou d'un medium.

L'invention se rapporte également à un procédé de manutention de composants horlogers comprenant une étape de transport et/ou de réalisation d'au moins une première opération sur les composants horlogers disposés sur un premier support, une étape de transfert automatique des composants horlogers depuis le premier support sur un deuxième support par l'intermédiaire d'un dispositif de tel que défini précédemment et/ou par l'intermédiaire d'un ensemble de dispositifs de transfert tel que défini précédemment, et une étape de transport et/ou de réalisation d'au moins une deuxième opération sur les composants horlogers disposés sur le deuxième support.

### Description sommaire des dessins

Ces objets, caractéristiques et avantages de la présente invention seront exposés en détail dans la description suivante d'un mode de réalisation particulier fait à titre non-limitatif en relation avec les figures jointes parmi lesquelles :
La figure 1 est une vue schématique d'un système de manutention de composants horlogers équipé d'un ensemble de deux dispositifs de transfert selon un mode de réalisation de l'invention.
La figure 2 est une vue isométrique d'un ensemble comprenant deux dispositifs de transfert selon un mode de réalisation de l'invention.
La figure 3 est une vue en éclaté de l'ensemble comprenant les deux dispositifs de transfert selon un mode de réalisation de l'invention.
La figure 4 est une vue de dessus d'un premier dispositif de transfert selon un mode de réalisation de l'invention.
La figure 5 est une vue de dessous d'un deuxième dispositif de transfert selon un mode de réalisation de l'invention.
La figure 6 est une vue en coupe de l'ensemble comprenant les deux dispositifs de transfert selon un mode de réalisation de l'invention.
La figure 7 est une vue isométrique de l'ensemble comprenant les deux dispositifs de transfert et d'une grille selon un mode de réalisation de l'invention.

### Description d'un mode de réalisation

Sur l'ensemble des figures et de la description, on considère que le dispositif de transfert de composants horlogers repose sur un sol horizontal. Les termes « haut » et « bas » sont définis en relation à un axe vertical.

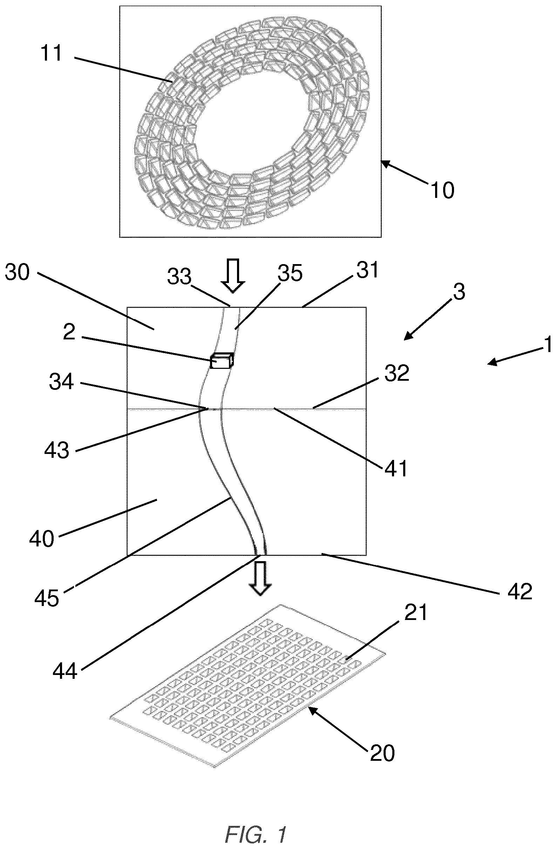

La figure 1 illustre schématiquement un système de manutention 1 de composants horlogers 2 selon un mode de réalisation de l'invention. Le système de manutention 1 comprend un premier support 10 comprenant des premiers logements 11 et un deuxième support 20 distinct du premier support 10, comprenant des deuxièmes logements 21. Les premiers logements 11 du premier support sont agencés sur le premier support selon un premier agencement et les deuxièmes logements 21 du deuxième support sont agencés sur le deuxième support selon un deuxième agencement, différent du premier agencement. Le système de manutention 1 comprend un ensemble 3 de deux dispositifs de transfert 30, 40 pour transférer des composants horlogers 2 depuis les premiers logements 11 du premier support 10 vers les deuxièmes logements 21 du deuxième support 20.

Les composants horlogers 2 peuvent être des composants d'une montre ou d'une horloge. Les composants horlogers peuvent être des ébauches, notamment des ébauches du mouvement comme des platines ou des ponts, des mobiles du mouvement comme des mobiles d'échappement, ou encore des composants d'habillage comme, par exemple, des maillons de bracelet ou des plaques de cadran ou des index de cadran ou des couronnes de remontoir. Selon le mode de réalisation présenté, les composants horlogers 2 sont des maillons de bracelet de forme sensiblement parallélépipédique. Les maillons de bracelet sont identiques entre eux mais en variante, le dispositif de transfert pourrait être utilisé pour conditionner des composants différents et de forme quelconque.

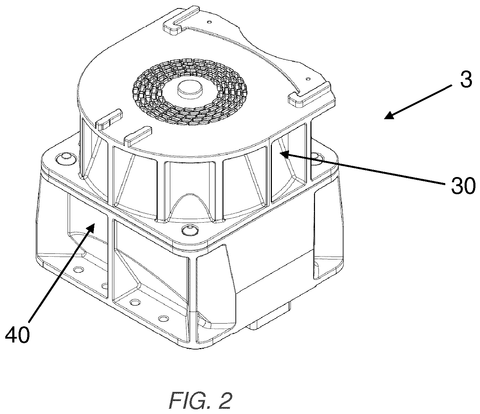

La figure 2 illustre un mode de réalisation selon l'invention de l'ensemble 3 comprenant deux dispositifs de transfert 30, 40 de composants horlogers 2. Les deux dispositifs de transferts 30, 40 sont disposés en série, c'est-à-dire l'un au-dessus de l'autre, de manière à pouvoir coopérer. L'invention porte également sur un unique dispositif de transfert utilisé isolément ou bien à un ensemble 3 comprenant un nombre quelconque de dispositifs de transfert disposés en série. En variante, les deux dispositifs de transfert 30, 40 que nous allons décrire, pourraient constituer une seule et même pièce.

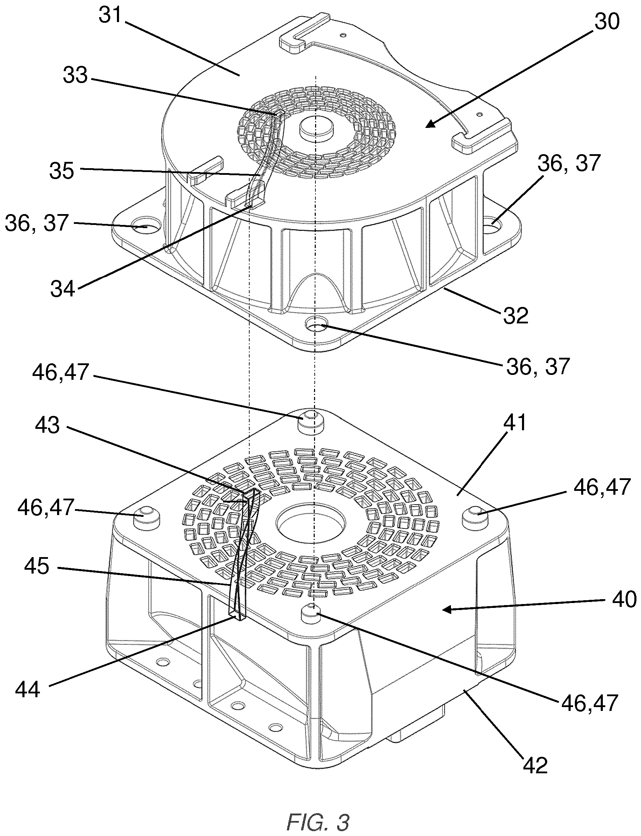

La figure 3 est une vue en éclaté de l'ensemble 3 dans laquelle on distingue plus nettement le premier dispositif de transfert 30 (en haut) et le deuxième dispositif de transfert 40 (en bas). Chacun des deux dispositifs de transfert 30, 40 a globalement la forme d'une boîte et comprend une face d'entrée 31, 41, ou face supérieure, orientée vers le haut et une face de sortie 32, 42, ou face inférieure, orientée vers le bas. Lorsque le premier dispositif de transfert 30 est disposé en série avec le deuxième dispositif de transfert 40, la face de sortie 32 du premier dispositif de transfert 30 est en appui contre la face d'entrée 41 ou tout au moins située vis-à-vis de la face d'entrée 41 du deuxième dispositif de transfert 40.

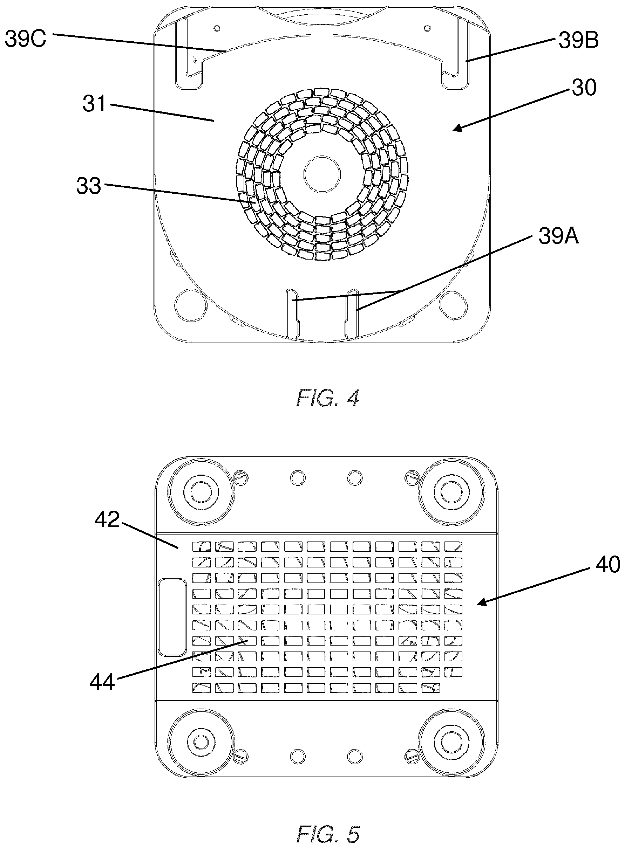

La face d'entrée 31 du premier dispositif de transfert 30 est plane et comprend une forme globalement circulaire. La face de sortie 32 est également plane et comprend une forme globalement carrée. Bien entendu, ces faces 31, 32 pourraient comprendre une forme de toute autre géométrie et pourraient, par exemple, être courbées ou discontinues et optionnellement comporter des moyens d'indexation. La face d'entrée 31 comprend des orifices d'entrée 33 agencés pour correspondre au premier agencement des composants horlogers 2 sur le premier support 10. Plus précisément, le premier agencement, particulièrement visible sur la figure 4, consiste en une disposition des orifices d'entrée 33 selon cinq cercles concentriques. La face de sortie 32 comprend des orifices de sortie 34 ordonnés selon un troisième agencement. Chaque orifice d'entrée 33 correspond à un composant horloger 2 à transférer. La face d'entrée 31, 41 et la face de sortie 32, 42 de chaque dispositif de transfert peuvent être parallèles entre elles.

De même, la face d'entrée 41 du deuxième dispositif de transfert 40 est plane et comprend une forme globalement carrée, de mêmes dimensions que la face de sortie 32 du premier dispositif de transfert 30. La face de sortie 42 du deuxième dispositif de transfert 40 est également plane et comprend une forme globalement carrée. La face d'entrée 41 comprend des orifices d'entrée 43 agencés pour correspondre au troisième agencement, c'est-à-dire à l'agencement des orifices de sortie 34 de la face de sortie 32 du premier dispositif de transfert 30. Plus précisément, le troisième agencement consiste en une disposition des orifices d'entrée 43 selon cinq cercles concentriques de plus grand diamètre que les cinq cercles concentriques définissant le premier agencement. On observe que les orifices d'entrée 43 du deuxième dispositif de transfert sont plus espacés les uns des autres que les orifices d'entrée 33 du premier dispositif de transfert. La face de sortie 42 comprend des orifices de sortie 44 agencés pour correspondre au deuxième agencement des composants horlogers 2 sur le deuxième support.

La figure 5 illustre l'agencement des orifices de sortie 44. Ils sont répartis selon un motif rectangulaire comprenant neuf rangées de douze orifices et une rangée de onze orifices. Quelle que soit la face considérée parmi les faces d'entrées 31, 41 ou les faces de sortie 32, 42, les orifices d'entrée 33, 43 et les orifices de sortie 34, 44 présentent une forme correspondant à la forme des composants horlogers 2 selon leur orientation prédéterminée. Selon le mode de réalisation présenté, cette forme est sensiblement rectangulaire mais pourrait, en variante, adopter toute autre forme. Le nombre d'orifices d'entrée 33 de la face d'entrée 31 du premier dispositif de transfert 30 est égal au nombre d'orifices de sortie 34 de la face de sortie 32 du premier dispositif de transfert 30, et également égal au nombre d'orifices d'entrée 43 de la face d'entrée 41 et au nombre d'orifices de sortie 44 de la face de sortie 42 du deuxième dispositif de transfert 40. Dans le mode de réalisation présenté, ce nombre est égal à cent dix-neuf mais en variante, il pourrait être différent. Les orifices d'entrée 33, 43 et/ou de sortie 34, 44 peuvent être chanfreinés pour, entre autre, améliorer le transfert des composants horlogers 2 et notamment pour éviter tout risque de coincement des composants horlogers 2.

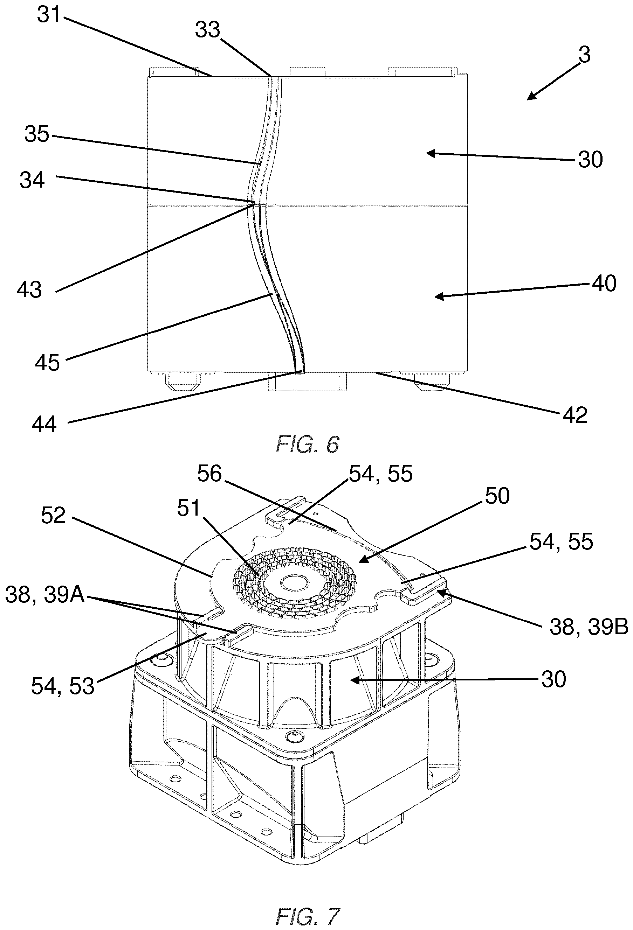

Chacun des deux dispositifs de transfert 30, 40 comprend des éléments de guidage 35, 45 aptes à guider automatiquement les composants horlogers 2 depuis les orifices d'entrée vers les orifices de sortie, c'est à dire sans manipulation supplémentaire de la part d'un opérateur. Les éléments de guidage 35, 45 se présentent sous la forme de canaux reliant chacun respectivement un orifice d'entrée positionné sur la face d'entrée du dispositif de transfert à un orifice de sortie positionné sur la face de sortie du dispositif de transfert. Les éléments de guidage 35, 45 comprennent des parois aptes à guider un composant horloger 2 depuis un orifice d'entrée vers un orifice de sortie. Le déplacement de chaque composant horloger 2 dans un élément de guidage 35, 45 est maitrisé de sorte à préserver l'intégrité des différentes surfaces du composant horloger 2 durant le transfert. Comme les orifices de sortie 34 du premier dispositif de transfert 30 coïncident avec les orifices d'entrée 43 du deuxième dispositif de transfert 40, les éléments de guidage 35, 45 sont reliés pour former des éléments de guidage continus sur l'ensemble des deux dispositifs de transfert. Cette continuité est notamment illustrée sur la figure 6. Avantageusement, non seulement les orifices de sortie 34 coïncident avec les orifices d'entrée 43, mais également l'orientation de l'élément de guidage 35 coïncide avec l'orientation de l'élément de guidage 45 au niveau du plan de séparation entre les deux dispositifs de transfert. Plus précisément, l'orientation de chaque élément de guidage peut être perpendiculaire à la face d'entrée ou à la face de sortie respectivement au niveau des orifices d'entrée et au niveau des orifices de sortie. Ainsi, un composant horloger 2 peut facilement coulisser de l'élément de guidage 35 à l'élément de guidage 45 sans risquer d'être bloqué à l'interface entre les deux dispositifs de transfert.

Les éléments de guidage 35, 45 peuvent comprendre tout ou partie des caractéristiques suivantes :
- une surface de guidage courbe ; et/ou
- une surface de guidage comprenant au moins une chicane ; et/ou
- une surface de guidage apte à induire le déplacement d'un composant horloger 2 selon une translation et/ou selon une rotation ; et/ou
- une surface de guidage apte à induire une modification ou non de l'orientation d'un composant horloger 2 ; et/ou
- une surface de guidage apte à induire une modification de l'orientation d'un composant horloger 2 de sorte que sa surface de contact avec un support soit différente sur les premier et deuxième supports.

Ainsi la forme et la configuration des éléments de guidage permettent de définir une transformation de l'agencement des composants horlogers 2. Comme on peut le constater en comparant les figures 4 et 5, entre le premier agencement et le deuxième agencement, les composants horlogers 2 ont subi un déplacement puisque leur position relative est passée d'une forme dont l'enveloppe dessine un cercle à une forme dont l'enveloppe dessine un rectangle. Entre le premier agencement et le deuxième agencement, les composants horlogers 2 ont également subi une modification de leur orientation puisque leur orientation est passée d'une orientation le long d'un cercle à une orientation où tous les composants horlogers 2 sont parallèles entre eux. D'une manière générale, chaque élément de guidage 35, 45 peut être défini pour imposer un déplacement d'un composant horloger 2 selon un ou plusieurs axes, notamment pour imposer une rotation du composant 2 horloger autour d'un ou plusieurs axes. La surface sur laquelle repose un composant horloger 2 dans le premier support 10 peut ainsi être différente de la surface sur laquelle repose le composant dans le deuxième support 20. Une telle rotation du composant horloger 2 peut être obtenue au moyen d'une chicane agencée dans l'élément de guidage correspondant.

Un ensemble 3 peut comprendre un nombre quelconque de dispositifs de transfert, y compris un unique dispositif de transfert, par exemple uniquement le premier dispositif de transfert 30 ou uniquement le deuxième dispositif de transfert 40. Avantageusement, des dispositifs de transfert définissant différentes transformations élémentaires de l'agencement des composants horlogers 2 peuvent être combinés en série dans un même ensemble 3 de manière à obtenir une transformation plus complexe de l'agencement des composants horlogers 2. On peut ainsi réaliser une grande diversité de transformations en combinant un nombre limité de dispositifs de transfert compatibles. Par ailleurs, le montage de plusieurs dispositifs de transfert en série permet de limiter la longueur de chaque élément de guidage et facilite la récupération de composants horlogers 2 qui se seraient malencontreusement bloqués dans le dispositif de transfert durant le transfert.

Selon une variante de réalisation, un dispositif de transfert peut être utilisé uniquement pour modifier l'orientation de composants horlogers 2 sans modifier leurs positions relatives. Selon une autre variante, un dispositif de transfert peut être utilisé pour changer ou intervertir les positions de différents composants horlogers sans modifier le motif dessiné par leur agencement. Avantageusement, un même dispositif de transfert peut être utilisé réversiblement, c'est-à-dire aussi bien pour passer d'un premier agencement à un deuxième agencement que pour passer du deuxième agencement au premier agencement. Dans un tel cas, le dispositif de transfert est retourné et les orifices de sorties sont utilisés comme orifice d'entrée et les orifices d'entrée sont utilisés comme orifice de sortie.

Selon une autre variante, un dispositif de transfert peut être agencé de sorte à regrouper ou à dégrouper des composants horloger 2 et avoir un nombre d'orifices d'entrée 33, 43 différent du nombre d'orifices de sortie 34, 44. Par exemple, un tel dispositif de transfert peut être utilisé pour regrouper deux composants horlogers 2 dans la même zone du deuxième support 20. Alternativement, lorsqu'on dégroupe des composants horlogers 2, certaines zones du deuxième support 20 peuvent être laissées vide, par exemple pour recevoir un composant horloger différent. A cet effet, selon la transformation souhaitée, deux éléments de guidages d'un même dispositif de transfert peuvent être reliés l'un à l'autre par un embranchement ou bien un même élément de guidage peut se séparer en deux branches distinctes.

Selon une autre variante, le premier support 10 et/ou le deuxième support 20 peuvent être un groupe de supports. Par exemple, pour séparer les composants vers au moins deux deuxièmes supports, les pièces de chacun de ces deuxièmes supports étant prévues, par exemple, pour subir des traitements de surface différents.

En référence à la figure 3, les deux dispositifs de transfert 30, 40 comprennent des moyens d'indexation 36, 46 permettant un positionnement unique des deux dispositifs de transfert l'un par rapport à l'autre. Sur le premier dispositif de transfert, le moyen d'indexation 36 est constitué par quatre trous 37 de forme circulaire agencés aux quatre coins de la face de sortie 32. Sur le deuxième dispositif de transfert, le moyen d'indexation 46 est constitué par quatre plots 47 de forme cylindrique agencés aux quatre coins de la face d'entrée 41. Les quatre plots 47 sont aptes à coopérer avec les quatre trous 37. Avantageusement, les moyens d'indexation sont prévus de manière à ce que les deux dispositifs de transfert 30, 40 puissent s'associer selon une orientation unique. Ainsi, l'un des quatre trous 37 comprend un diamètre plus faible que les trois autres trous de sorte à ne pouvoir coopérer qu'avec un seul des quatre plots 47 présentant également un diamètre plus faible. On évite ainsi d'emboîter les deux dispositifs de transfert avec une rotation d'un quart de tour inappropriée.

Comme illustré sur la figure 7, le dispositif de transfert 30 peut comprendre une grille 50 amovible comprenant des orifices de grille 51 agencés de manière identique ou compatible aux orifices d'entrée 33 de la face d'entrée 31. Les orifices de grilles 51 peuvent être superposés aux orifices d'entrée 33 de la face d'entrée 31 pour permettre le passage des composants horlogers 2 successivement au travers des orifices de grille 51 et des orifices d'entrée 33. La grille a une forme globalement plane. Elle présente une première portion en arc de cercle 52 prolongée par un manche 53. Les orifices de grille 51 peuvent éventuellement être chanfreinés.

Avantageusement, la face d'entrée 31 du premier dispositif de transfert 30 et/ou la grille comprennent des moyens d'indexation 38, 54 pour le bon positionnement de la grille 50 relativement à la face d'entrée 31. Sur la face d'entrée 31, le moyen d'indexation 38 est constitué par des saillies 39A, 39B verticales définissant des logements dans lesquels la grille 50 peut s'emboîter. Sur la grille 50, le moyen d'indexation 54 est constitué, d'une part, par le manche 53 apte à se loger entre deux premières saillies 39A de part et d'autre du manche 53. D'autre part, le moyen d'indexation 54 comprend également deux appendices 55 reliés par une deuxième portion en arc de cercle 56. Les deux appendices 55 sont aptes à prendre appui contre deux deuxièmes saillies 39B. Dans cette position, la deuxième portion en arc de cercle 56 est également en butée contre un moyen de butée 39C conjugué agencé sur la face d'entrée 31 du premier dispositif de transfert 30. Ainsi, la grille peut être mise en position de manière unique par rapport au premier dispositif de transfert en la faisant glisser dans le plan de la face d'entrée 31 de sorte à ce que le manche 53 passe entre les deux premières saillies 39A et jusqu'à ce que les deux premières saillies 39A viennent en butée contre la première portion en arc de cercle 52. Dans une telle position, les orifices de grille 51 coïncident avec les orifices d'entrée 33 du premier dispositif de transfert. Une extrémité du manche 53 peut dépasser du dispositif de transfert de sorte qu'un opérateur peut facilement saisir la grille pour la déplacer.

La grille peut être réalisée dans un même matériau que la face d'entrée 31 ou dans un matériau différent, à la fois résistant à l'abrasion et préservant l'intégrité des surfaces des composants horlogers 2. L'utilisation répétée d'un dispositif de transfert équipé d'une grille peut conduire à une usure de la surface de la grille. Avantageusement, la grille 50 est simple à fabriquer et peut être remplacée facilement par une nouvelle grille identique. Ainsi il n'est pas nécessaire de fabriquer un nouveau dispositif de transfert en raison de l'usure liée à une utilisation intensive.

De manière optionnelle, le premier dispositif de transfert peut comprendre une plaque (non représentée) disposée de manière amovible entre la face d'entrée 31 du premier dispositif de transfert 30 et la grille 50 pour permettre un maintien temporaire des composants horlogers 2 au-dessus de la face d'entrée 31 avant leur transfert au travers des orifices d'entrée 33. Le retrait de la plaque libère les orifices d'entrée permettant ainsi aux composants horlogers 2 de traverser le dispositif de transfert.

En variante, la plaque peut comprendre des ouvertures selon un agencement identique ou compatible avec les orifices d'entrée 33 et être mobile relativement à la face d'entrée 31, de sorte à pouvoir occuper deux positions. Dans une première position, les ouvertures de la plaque ne sont pas totalement superposées avec les orifices d'entrée 33 de sorte que des composants horlogers 2 sont aptes à rester maintenus sur la plaque. Dans une deuxième position, les ouvertures de la plaque sont superposées avec des orifices d'entrée 33 de sorte que des composants horlogers 2 sont aptes à être transférés au travers des ouvertures de la plaque et des orifices d'entrée 33. Un déplacement de la plaque de la première position à la deuxième position provoque le déplacement de tous les composants horlogers 2 à l'aplomb des orifices d'entrée 33 et ceux-ci peuvent alors traverser le dispositif de transfert.

Le premier support 10 peut être un plateau ou une navette. Le deuxième support 20 peut être un plateau ou une navette ou une cuve, en particulier une cuve remplie de liquide ou d'un medium. Le premier support et le deuxième support sont des conditionnements adaptés à l'exécution d'une étape d'un procédé de fabrication d'une montre. Avantageusement, la présence de liquide, ou d'un medium, amortit la chute des composants horlogers 2 au sein du deuxième support 20 et/ou au travers des éléments de guidage 35, 45. Les composants horlogers 2 atteignent le deuxième support 20 en douceur et ne s'entrechoquent pas. Alternativement ou complémentairement, le dispositif de transfert peut être immergé ou rempli d'un medium.

Le premier dispositif de transfert 30 comprend un flanc globalement cylindrique et pourvu de nervures de rigidification. Le deuxième dispositif de transfert 40 comprend des flancs globalement rectangulaires et également pourvus de nervures de rigidification. Ainsi, chaque dispositif de transfert est rigide et solide, et est ainsi adapté à une utilisation dans un atelier de production.

Chaque dispositif de transfert peut être monobloc et compact. Il peut être fabriqué en polymère ou revêtu au moins partiellement d'une surface en polymère, ou en céramique, ou en métal, notamment en alliage de métaux, pour préserver l'intégrité des composants horlogers 2, notamment pour éviter de les déformer ou de les rayer ou pour faciliter leur transfert. Avantageusement il est fabriqué dans un matériau compatible avec une fabrication par addition de matière, également dénommée synthèse additive, impression 3D ou encore impression tridimensionnelle. La synthèse additive permet de produire un objet réel, en utilisant une installation spécifique qui dépose et/ou solidifie de la matière, couche par couche, pour obtenir un volume. Notamment, le dispositif de transfert peut être fabriqué à l'aide de l'une des technologies suivantes :
i. le modelage par dépôt de matière en fusion, également dénommé « FDM » comme les initiales de « Fuse Deposition Modeling » ; ou
ii. la polymérisation ou réticulation par couche d'un polymère, notamment la stéreolithographie, notamment la stéreolithographie par photopolymérisation ou SLA ; ou
iii. le collage de film avec un adhésif, également dénommé « LOM » comme les initiales de « Laminated Object Manufacturing » ; ou
iv. l'agglomération d'une couche de poudre par frittage laser, également dénommé « SLS » comme les initiales de « Selective Laser Sintering » ou frittage sélectif par laser ; ou
v. la fusion de poudre à l'aide d'un laser, également dénommée « SLM » comme les initiales de « Selective Laser Melting ».

Ces techniques de fabrication permettent la conception de dispositifs de transfert comprenant des éléments de guidage 35, 45 avec des formes complexes, notamment des formes courbes ou sinueuses. Ces techniques de fabrication ont également une très bonne reproductibilité et permettent un processus de fabrication très automatisé. Ainsi, on s'affranchit des contraintes de fabrication imposées notamment par le moulage ou par le perçage.

L'invention se rapporte également à un procédé de manutention de composants horlogers 2. Le procédé de manutention comprend une étape de transport et/ou de réalisation d'au moins une première opération sur les composants horlogers 2. Cette première opération peut être par exemple une opération d'usinage, notamment de perçage, de taraudage, de fraisage, de tournage, ou encore de décolletage. La première opération peut également être une opération de lavage ou de terminaison comme notamment une opération de polissage, un dépôt de couches de finitions, notamment de couches galvaniques ou de couche de décors. Cette première opération peut s'effectuer au moyen d'une machine-outil. Au cours de cette opération, ou tout au moins à l'issue de cette première opération, les composants horlogers 2 sont disposés sur le premier support 10 selon le premier agencement.

Puis, le procédé de manutention comprend une étape de transfert automatique des composants horlogers 2 depuis le premier support 10 sur un deuxième support 20 par l'intermédiaire de l'ensemble 3 comprenant les deux dispositifs de transfert 30, 40. Les composants horlogers 2 sont insérés depuis le premier support dans les orifices d'entrée 33 dont l'agencement est adapté à l'agencement des composants horlogers 2 dans le premier support. Puis, les composants horlogers 2 glissent le long des parois des éléments de guidage 35,45 jusqu'aux orifices de sortie 44. Les composants horlogers 2 passent ainsi du premier agencement au deuxième agencement sous le seul effet de la gravité, sans intervention d'un opérateur. On comprend donc que les dispositifs de transfert reposent de préférence sur un plan horizontal ou quasiment horizontal. Entre le premier agencement et le deuxième agencement, les composants horlogers 2 passent, à l'interface entre le premier dispositif de transfert 30 et le deuxième dispositif de transfert 40, par le troisième agencement, qui est donc un agencement transitoire.

Puis le procédé de manutention comprend une étape de transport et/ou de réalisation d'au moins une deuxième opération sur les composants horlogers 2 disposés sur le deuxième support 20 et selon le deuxième agencement. Cette deuxième opération peut être par exemple une opération d'usinage, notamment de perçage, de taraudage, de fraisage, de tournage, ou encore de décolletage. La deuxième opération peut également être une opération lavage ou de terminaison comme notamment opération de polissage, un dépôt de couches de finitions, notamment de couches galvaniques ou de couche de décors. Cette deuxième opération peut s'effectuer au moyen d'une machine-outil et nécessite un positionnement précis des composants horlogers 2, selon le deuxième agencement.

Grâce à l'invention, on dispose d'un dispositif de transfert facilitant les transformations d'agencement de composants horlogers 2 et simplifiant ainsi le procédé de fabrication d'une montre ou d'une horloge. Les composants horlogers 2 sont ainsi ré-agencés rapidement, sans manipulation et sans risque de les endommager.

## Revendications

1. Système de manutention (1) de composants horlogers (2), comprenant un premier support (10) qui est un plateau ou une navette comprenant des premiers logements (11) qui sont agencés selon un premier agencement, et sur lesquels sont disposés les composants horlogers de sorte qu'ils reposent sur une certaine surface, pour le transport et/ou la mise en œuvre d'au moins une première opération sur les composants horlogers (2), ledit système comprend un deuxième support (20) distinct pour le transport et/ou la mise en œuvre d'au moins une deuxième opération sur les mêmes composants horlogers (2) et comprend au moins un dispositif de transfert (30, 40) pour transférer les composants horlogers (2) depuis les premiers logements (11) du premier support (10) vers le deuxième support (20), le dispositif de transfert (30, 40) de plusieurs composants horlogers (2) comprenant une face d'entrée (31, 41) comprenant des orifices d'entrée (33, 43) agencés pour correspondre à un premier agencement des composants horlogers (2) sur le premier support (10), une face de sortie (32, 42) comprenant des orifices de sortie (34, 44) agencés pour correspondre à un deuxième agencement des composants horlogers (2) sur le deuxième support (20), et des éléments de guidage (35, 45) aptes à guider automatiquement les composants horlogers (2) depuis les orifices d'entrée (33, 43) vers les orifices de sortie (34, 44).

2. Système de manutention (1) de composants horlogers (2) selon la revendication précédente, **caractérisé en ce que** les éléments de guidage (35, 45) se présentent sous la forme de canaux reliant chacun respectivement un orifice d'entrée (33, 43) positionné sur la face d'entrée (31, 41) à un orifice de sortie (34, 44) positionné sur la face de sortie (32, 42), au moins un élément de guidage (35, 45) induisant le glissement d'un composant horloger (2) sur une paroi dudit au moins un élément de guidage (35, 45) depuis un orifice d'entrée (33, 43) jusqu'à un orifice de sortie (34, 44).

3. Système de manutention (1) de composants horlogers (2) selon l'une des revendications précédentes, **caractérisé en ce qu'**au moins un élément de guidage (35, 45) comprend tout ou partie des caractéristiques suivantes :
- une surface de guidage courbe ; et/ou
- une surface de guidage comprenant au moins une chicane ; et/ou
- une surface de guidage apte à induire le déplacement d'un composant horloger (2) selon une translation et/ou selon une rotation ; et/ou
- une surface de guidage apte à induire une modification ou non de l'orientation d'un composant horloger (2); et/ou
- une surface de guidage apte à induire une modification de l'orientation d'un composant horloger (2) de sorte que sa surface de contact avec le premier support (10) soit différente de sa surface de contact avec le deuxième support (20).

4. Système de manutention (1) de composants horlogers (2) selon l'une des revendications précédentes, **caractérisé en ce que** le dispositif de transfert (30, 40) est en polymère ou revêtu au moins partiellement d'une surface en polymère, ou en céramique, ou en métal, notamment en alliage de métaux, pour éviter de choquer les composants horlogers (2).

5. Système de manutention (1) de composants horlogers (2) selon l'une des revendications précédentes, **caractérisé en ce qu'**il comprend une grille (50) amovible comprenant des orifices de grille (51) agencés de manière identique ou compatible aux orifices d'entrée (33) de la face d'entrée (31) du dispositif de transfert (30, 40) pour pouvoir être superposés à ces orifices d'entrée (33) de la face d'entrée (31) et permettre le passage de composants horlogers (2) successivement au travers des orifices de grille (51) et des orifices d'entrée (33).

6. Système de manutention (1) de composants horlogers (2) selon la revendication précédente, **caractérisé en ce que** la grille (50) et la face d'entrée (31) comprennent un moyen d'indexation (38, 54) pour le bon positionnement de la grille (50) relativement à la face d'entrée (31).

7. Système de manutention (1) de composants horlogers (2) selon l'une des revendications 5 ou 6, **caractérisé en ce qu'**il comprend une plaque disposée de manière amovible entre la face d'entrée (31) du premier dispositif de transfert (30) et la grille (50) pour permettre un maintien temporaire de composants horlogers (2) sur la face d'entrée avant leur transfert au travers des orifices d'entrée (33) après retrait ou déplacement de la plaque.

8. Système de manutention (1) de composants horlogers (2) selon la revendication précédente, **caractérisé en ce que** la plaque comprend des ouvertures selon un agencement identique ou compatible avec les orifices d'entrée (33) de la face d'entrée (31), et **en ce que** la plaque est mobile relativement à la face d'entrée, de sorte à pouvoir occuper deux positions, une première position dans laquelle ses ouvertures ne sont pas totalement superposées avec les orifices d'entrée (33) de la face d'entrée (31) de sorte que des composants horlogers (2) sont aptes à rester maintenus au-dessus de la face d'entrée (31), et une deuxième position dans laquelle ses ouvertures sont superposées avec des orifices d'entrée (33) de la face d'entrée (31) de sorte que des composants horlogers (2) sont aptes à être transférés au travers des ouvertures de la plaque et des orifices d'entrée (33) de la face d'entrée (31).

9. Système de manutention (1) de composants horlogers (2) selon l'une des revendications précédentes, **caractérisé en ce qu'**il est apte au transfert d'ébauches d'un mouvement horloger comme des platines ou des ponts, des mobiles du mouvement horloger comme des mobiles d'échappement, ou encore des composants horlogers d'habillage, comme des maillons de bracelet ou des plaques de cadran ou des index de cadran.

10. Système de manutention (1) de composants horlogers (2) selon l'une des revendications précédentes, **caractérisé en ce qu'**il comprend un dispositif de transfert (30, 40) apte à être monté en série avec au moins un deuxième dispositif (40) de transfert, notamment **en ce qu'**il comprend des moyens d'indexation (36, 46) et/ou de maintien d'un deuxième dispositif de transfert (40), au niveau de sa face d'entrée (41) et/ou au niveau d'une face de sortie (32).

11. Système de manutention (1) selon l'une des revendications précédentes, **caractérisé en ce qu'**il comprend au moins deux dispositifs de transfert (30, 40) de composants horlogers (2) disposés en série, comprenant chacun des éléments de guidage (35, 45) respectifs, de sorte que ces éléments de guidage (35, 45) respectifs sont reliés pour former des éléments de guidage (35, 45) continus sur l'ensemble des au moins deux dispositifs de transfert (30, 40).

12. Système de manutention (1) de composants horlogers (2) selon l'une des revendications précédentes, **caractérisé en ce que** le deuxième support (20) comporte des deuxièmes logements (21), le dispositif de transfert (30, 40) étant apte à transférer des composants horlogers (2) depuis les premiers logements (11) du premier support (10) vers les deuxièmes logements (21) du deuxième support (20).

13. Système de manutention (1) de composants horlogers (2) selon l'une des revendications précédentes, **caractérisé en ce que** le deuxième support (20) est un plateau ou une navette ou une cuve, en particulier une cuve remplie de liquide ou d'un medium.

14. Procédé de fabrication d'un dispositif de transfert (30, 40) d'un système de manutention (1) de composants horlogers (2) selon l'une des revendications précédentes, **caractérisé en ce qu'**il comprend une étape de fabrication par addition de matière, notamment selon l'une des technologies suivantes :
i. le modelage par dépôt de matière en fusion ; ou
ii. la polymérisation ou réticulation par couche d'un polymère, notamment la stéreolithographie ; ou
iii. le collage de film avec un adhésif (LOM pour Laminated Object Manufacturing) ; ou
iv. l'agglomération d'une couche de poudre par frittage laser SLS (frittage sélectif par laser) ; ou
v. la fusion de poudre à l'aide d'un laser (SLM pour selective laser melting).

15. Procédé de manutention de composants horlogers (2), comprenant une étape de transport et/ou de réalisation d'au moins une première opération sur les composants horlogers (2) disposés sur un premier support (10), et **caractérisé en ce qu'**il comprend une étape de transfert automatique des composants horlogers (2) depuis le premier support (10) sur un deuxième support (20) par l'intermédiaire d'un dispositif de transfert (30, 40) d'un système de manutention (1) selon l'une des revendications 1 à 13, et **en ce qu'**il comprend une étape de transport et/ou de réalisation d'au moins une deuxième opération sur les composants horlogers (2) disposés sur le deuxième support (20).

## Patentansprüche

1. Fördersystem (1) für Uhrenkomponenten (2), beinhaltend einen ersten Träger (10), der eine Schale oder ein Tablett ist, die/das erste Aufnahmeplätze (11) beinhaltet, die gemäß einer ersten Anordnung angeordnet sind und in denen die Uhrenkomponenten so angeordnet sind, dass sie auf einer gewissen Oberfläche aufliegen, für den Transport und/oder die Umsetzung mindestens eines ersten Vorgangs an den Uhrenkomponenten (2), wobei das System einen zweiten, unterschiedlichen Träger (20) für den Transport und/oder die Umsetzung mindestens eines zweiten Vorgangs an denselben Uhrenkomponenten (2) beinhaltet und mindestens eine Transfervorrichtung (30, 40) zum Transferieren der Uhrenkomponenten (2) von den ersten Aufnahmeplätzen (11) des ersten Trägers (10) zu dem zweiten Träger (20) beinhaltet, wobei die Transfervorrichtung (30, 40) für mehrere Uhrenkomponenten (2) eine Eintrittsseite (31, 41), die Eintrittsöffnungen (33, 43) beinhaltet, die dazu angeordnet sind, einer ersten Anordnung der Uhrenkomponenten (2) auf dem ersten Träger (10) zu entsprechen, eine Austrittsseite (32, 42), die Austrittsöffnungen (34, 44) beinhaltet, die dazu angeordnet sind, einer zweiten Anordnung der Uhrenkomponenten (2) auf dem zweiten Träger (20) zu entsprechen, und Führungselemente (35, 45), die dazu fähig sind, die Uhrenkomponenten (2) automatisch von den Eintrittsöffnungen (33, 43) zu den Austrittsöffnungen (34, 44) zu führen, beinhaltet.

2. Fördersystem (1) für Uhrenkomponenten (2) nach dem vorhergehenden Anspruch, **dadurch gekennzeichnet, dass** die Führungselemente (35, 45) die Form von Kanälen aufweisen, die jeder jeweils eine Eintrittsöffnung (33, 43), die an der Eintrittsseite (31, 41) positioniert ist, mit einer Austrittsöffnung (34, 44), die an der Austrittsseite (32, 42) positioniert ist, verbinden, wobei mindestens ein Führungselement (35, 45) das Gleiten einer Uhrenkomponente (2) an einer Wand des mindestens einen Führungselements (35, 45) von einer Eintrittsöffnung (33, 43) bis zu einer Austrittsöffnung (34, 44) bewirkt.

3. Fördersystem (1) für Uhrenkomponenten (2) nach einem der vorhergehenden Ansprüche, **dadurch gekennzeichnet, dass** mindestens ein Führungselement (35, 45) alle oder einen Teil der folgenden Merkmale beinhaltet:
- eine gekrümmte Führungsoberfläche; und/oder
- eine Führungsoberfläche, die mindestens eine Umlenkfläche beinhaltet; und/oder
- eine Führungsoberfläche, die dazu fähig ist, die Bewegung einer Uhrenkomponente (2) gemäß einer Translation und/oder gemäß einer Rotation zu bewirken; und/oder
- eine Führungsoberfläche, die dazu fähig ist, eine oder keine Änderung der Ausrichtung einer Uhrenkomponente (2) zu bewirken; und/oder
- eine Führungsoberfläche, die dazu fähig ist, eine Änderung der Ausrichtung einer Uhrenkomponente (2) so zu bewirken, dass sich deren Kontaktoberfläche mit dem ersten Träger (10) von deren Kontaktoberfläche mit dem zweiten Träger (20) unterscheidet.

4. Fördersystem (1) für Uhrenkomponenten (2) nach einem der vorhergehenden Ansprüche, **dadurch gekennzeichnet, dass** die Transfervorrichtung (30, 40) aus Polymer besteht oder mindestens teilweise mit einer Polymeroberfläche beschichtet ist oder aus Keramik oder aus Metall, insbesondere aus einer Metalllegierung, besteht, um zu verhindern, dass die Uhrenkomponenten (2) durch Kollision beschädigt werden.

5. Fördersystem (1) für Uhrenkomponenten (2) nach einem der vorhergehenden Ansprüche, **dadurch gekennzeichnet, dass** es ein entfernbares Gitter (50) beinhaltet, das Gitteröffnungen (51) beinhaltet, die zu den Eintrittsöffnungen (33) der Eintrittsseite (31) der Transfervorrichtung (30, 40) identisch oder kompatibel angeordnet sind, um über diese Eintrittsöffnungen (33) der Eintrittsseite (31) gelegt werden zu können und den Durchgang von Uhrenkomponenten (2) zuerst durch die Gitteröffnungen (51) und dann durch die Eintrittsöffnungen (33) zu ermöglichen.

6. Fördersystem (1) für Uhrenkomponenten (2) nach dem vorhergehenden Anspruch, **dadurch gekennzeichnet, dass** das Gitter (50) und die Eintrittsseite (31) ein Indexierungsmittel (38, 54) für die korrekte Positionierung des Gitters (50) relativ zu der Eintrittsseite (31) beinhalten.

7. Fördersystem (1) für Uhrenkomponenten (2) nach einem der Ansprüche 5 oder 6, **dadurch gekennzeichnet, dass** es eine Platte beinhaltet, die entfernbar zwischen der Eintrittsseite (31) der ersten Transfervorrichtung (30) und dem Gitter (50) angeordnet ist, um ein vorübergehendes Halten von Uhrenkomponenten (2) auf der Eintrittsseite vor ihrem Transfer durch die Eintrittsöffnungen (33) nach Entfernung oder Bewegung der Platte zu ermöglichen.

8. Fördersystem (1) für Uhrenkomponenten (2) nach dem vorhergehenden Anspruch, **dadurch gekennzeichnet, dass** die Platte Aperturen gemäß einer zu den Eintrittsöffnungen (33) der Eintrittsseite (31) identischen oder kompatiblen Anordnung beinhaltet und dass die Platte in Bezug auf die Eintrittsseite beweglich ist, um zwei Positionen einnehmen zu können, eine erste Position, in der ihre Aperturen nicht komplett über den Eintrittsöffnungen (33) der Eintrittsseite (31) liegen, sodass die Uhrenkomponenten (2) dazu fähig sind, oberhalb der Eintrittsseite (31) gehalten zu bleiben, und eine zweite Position, in der ihre Aperturen über den Eintrittsöffnungen (33) der Eintrittsseite (31) liegen, sodass die Uhrenkomponenten (2) dazu fähig sind, durch die Aperturen der Platte und die Eintrittsöffnungen (33) der Eintrittsseite (31) transferiert zu werden.

9. Fördersystem (1) für Uhrenkomponenten (2) nach einem der vorhergehenden Ansprüche, **dadurch gekennzeichnet, dass** es dazu fähig ist, Rohwerke eines Uhrwerks, wie etwa Platinen oder Brücken, Drehteile des Uhrwerks, wie etwa Hemmungsdrehteile, oder aber Ausstattungskomponenten von Uhren, wie etwa Armbandglieder oder Zifferblattscheiben oder Zifferblattindizes, zu transferieren.

10. Fördersystem (1) für Uhrenkomponenten (2) nach einem der vorhergehenden Ansprüche, **dadurch gekennzeichnet, dass** es eine Transfervorrichtung (30, 40) beinhaltet, die dazu fähig ist, mit mindestens einer zweiten Transfervorrichtung (40) in Reihe montiert zu sein, insbesondere dass diese Indexierungsmittel (36, 46) und/oder Mittel zum Halten einer zweiten Transfervorrichtung (40) im Bereich ihrer Eintrittsseite (41) und/oder im Bereich ihrer Austrittsseite (32) beinhaltet.

11. Fördersystem (1) nach einem der vorhergehenden Ansprüche, **dadurch gekennzeichnet, dass** es mindestens zwei Transfervorrichtungen (30, 40) für Uhrenkomponenten (2) beinhaltet, die in Reihe angeordnet sind und jeweils jeweilige Führungselemente (35, 45) derart beinhalten, dass diese jeweiligen Führungselemente (35, 45) verbunden sind, um durchgehende Führungselemente (35, 45) für die Gesamtheit der mindestens zwei Transfervorrichtungen (30, 40) zu bilden.

12. Fördersystem (1) für Uhrenkomponenten (2) nach einem der vorhergehenden Ansprüche, **dadurch gekennzeichnet, dass** der zweite Träger (20) zweite Aufnahmeplätze (21) umfasst, wobei die Transfervorrichtung (30, 40) dazu fähig ist, Uhrenkomponenten (2) von den ersten Aufnahmeplätzen (11) des ersten Trägers (10) zu den zweiten Aufnahmeplätzen (21) des zweiten Trägers (20) zu transferieren.

13. Fördersystem (1) für Uhrenkomponenten (2) nach einem der vorhergehenden Ansprüche, **dadurch gekennzeichnet, dass** der zweite Träger (20) eine Schale oder ein Tablett oder ein Behälter, insbesondere ein mit einer Flüssigkeit oder einem Medium gefüllter Behälter, ist.

14. Verfahren zur Fertigung einer Transfervorrichtung (30, 40) eines Fördersystems (1) für Uhrenkomponenten (2) nach einem der vorhergehenden Ansprüche, **dadurch gekennzeichnet, dass** es einen Schritt des generativen Fertigens beinhaltet, insbesondere mit einer der folgenden Technologien:
i. Aufschmelzen von Materialschichten; oder
ii. Polymerisation oder schichtweise Vernetzung eines Polymers, insbesondere Stereolithografie; oder
iii. Verkleben von Folien (LOM, Laminated Object Manufacturing); oder
iv. Agglomerieren einer Pulverschicht durch Lasersintern SLS (selektives Lasersintern); oder
v. Schmelzen von Pulver mit Hilfe eines Lasers (SLM, Selective Laser Melting).

15. Verfahren zur Förderung von Uhrenkomponenten (2), beinhaltend einen Schritt des Transportierens und/oder des Durchführens mindestens eines ersten Vorgangs an den Uhrenkomponenten (2), die auf einem ersten Träger (10) angeordnet sind, und **dadurch gekennzeichnet, dass** es einen Schritt des automatischen Transferierens der Uhrenkomponenten (2) von dem ersten Träger (10) zu einem zweiten Träger (20) mittels einer Transfervorrichtung (30, 40) eines Fördersystems (1) nach einem der Ansprüche 1 bis 13 beinhaltet und dass es einen Schritt des Transportierens und/oder des Durchführens mindestens eines zweiten Vorgangs an den Uhrenkomponenten (2), die auf dem zweiten Träger (20) angeordnet sind, beinhaltet.

## Claims

1. System (1) for handling watch components (2), comprising a first support (10) which is a tray or a container comprising first housings (11) so arranged as to correspond to a first arrangement, and on which are placed the watch components so that they rest on a certain surface, for the transport and/or the implementation of at least one first operation on the watch components (2), said system comprises a second, distinct support (20) comprising second housings (21) for the transport and/or the implementation of at least one second operation on the same watch components (2), and comprises at least a transfer device (30, 40) for transferring the watch components (2) from the first housings (11) of the first support (10) to the second support (20), the device (30, 40) for the transfer of a plurality of watch components (2) comprising an inlet surface (31, 41) comprising inlet orifices (33, 43) so arranged as to correspond to a first arrangement of the watch components (2) on the first support (10), an outlet surface (32, 42) comprising outlet orifices (34, 44) so arranged as to correspond to a second arrangement of the watch components (2) on the second support (20), and guide elements (35, 45) adapted to guide the watch components (2) automatically from the inlet orifices (33, 43) to the outlet orifices (34, 44).

2. System (1) for handling watch components (2) as claimed in the preceding claim, **characterized in that** the guide elements (35, 45) are in the form of channels each respectively connecting an inlet orifice (33, 43) positioned on the inlet surface (31, 41) to an outlet orifice (34, 44) positioned on the outlet surface (32, 42), at least one guide element (35, 45) causing the sliding of a watch component (2) on a wall of said at least one guide element (35, 45) from an inlet orifice (33, 43) to an outlet orifice (34, 44).

3. System (1) for handling watch components (2) as claimed in one of the preceding claims, **characterized in that** at least one guide element (35, 45) comprises all or some of the following characterizing features:
- a curved guide surface; and/or
- a guide surface comprising at least one chicane; and/or
- a guide surface adapted to cause the displacement of a watch component (2) according to a translatory movement and/or according to a rotational movement; and/or
- a guide surface adapted to cause or not to cause a modification to the orientation of a watch component (2); and/or
- a guide surface adapted to cause a modification to the orientation of a watch component (2) in such a way that its contact surface with the first support (10) is different from its contact surface with the second support (20).

4. System (1) for handling watch components (2) as claimed in one of the preceding claims, **characterized in that** the transfer device (30, 40) is made of polymer or coated at least partially with a surface made of polymer, or ceramic, or metal, especially an alloy of metals, in order to avoid clattering the watch components (2).

5. System (1) for handling watch components (2) as claimed in one of the preceding claims, **characterized in that** it comprises a removable grille (50) comprising grille orifices (51) arranged in a manner that is identical or compatible with the inlet orifices (33) of the inlet surface (31) of the transfer device (30, 40) in order to be capable of being overlaid on these inlet orifices (33) of the inlet surface (31) and to permit the passage of watch components (2) successively through the grille orifices (51) and the inlet orifices (33).

6. System (1) for handling watch components (2) as claimed in the preceding claim, **characterized in that** the grille (50) and the inlet surface (31) comprise a means of indexation (38, 54) for the correct positioning of the grille (50) relative to the inlet surface (31).

7. System (1) for handling watch components (2) as claimed in one of claims 5 and 6, **characterized in that** it comprises a plate arranged in a removable manner between the inlet surface (31) of the first transfer device (30) and the grille (50) in order to permit the temporary retention of watch components (2) on the inlet surface before their transfer through the inlet orifices (33) after retraction or displacement of the plate.

8. System (1) for handling watch components (2) as claimed in the preceding claim, **characterized in that** the plate comprises openings according to an arrangement that is identical to or compatible with the inlet orifices (33) of the inlet surface (31), and **in that** the plate is mobile relative to the inlet surface, in such a way as to be capable of occupying two positions, a first position in which its openings are not totally overlapped by the inlet orifices (33) of the inlet surface (31) in such a way that watch components (2) are adapted to continue to be retained above the inlet surface (31), and a second position in which its openings are overlapped by inlet orifices (33) of the inlet surface (31) in such a way that watch components (2) are adapted to be transferred through the openings in the plate and the inlet orifices (33) of the inlet surface (31).

9. System (1) for handling watch components (2) as claimed in one of the preceding claims, **characterized in that** it is adapted for the transfer of movement-blanks such as plates or bridges, wheels of the watch movement such as escape wheels, or even watch-making components such as bracelet links or dial plates or dial indices.

10. System (1) for handling watch components (2) as claimed in one of the preceding claims, **characterized in that** it comprises a transfer device (30, 40) adapted to be mounted in series with at least one second transfer device (40), and especially **in that** it comprises means of indexation (36, 46) and/or of retention of a second transfer device (40) in the area of its inlet surface (41) and/or in the area of an outlet surface (32).

11. System (1) for handling watch components (2) as claimed in one of the preceding claims, **characterized in that** it comprises at least two devices (30, 40) for the transfer of watch components (2) arranged in series, comprising each respective guide elements (35, 45), in such a way that these respective guide elements (35, 45) are connected in order to form continuous guide elements (35, 45) on the assembly of the at least two transfer devices (30, 40).

12. System (1) for handling watch components (2) as claimed in one of the preceding claims, **characterized in that** it the second support (20) comprises second housings (21), the transfer device (30, 40) being able to transfer the watch components (2) from the first housings (11) of the first support (10) to the second housings (21) of the second support (20).

13. System (1) for handling watch components (2) as claimed in one of the preceding claims, **characterized in that** the second support (20) is a tray or a container or a vessel, in particular a vessel filled with liquid or with a medium.

14. Method of manufacturing a transfer device (30, 40) of a system (1) for handling watch components (2) as claimed in one of the preceding claims, **characterized in that** it comprises a stage of manufacture by the addition of material, especially according to one of the following technologies:
i. modeling by deposition of molten material; or
ii. polymerization or reticulation by layer of a polymer, especially stereolithography; or
iii. bonding of film with an adhesive (LOM, for Laminated Object Manufacturing); or
iv. agglomeration of a layer of powder by laser sintering, SLS (selective laser sintering); or
v. melting of powder with the aid of a laser (SLM, for selective laser melting).

15. Method of handling watch components (2), comprising a stage of transport and/or of performing at least one first operation on the watch components (2) arranged on a first support (10), and **characterized in that** it comprises a stage for the automatic transfer of the watch components (2) from the first support (10) onto a second support (20) by means of a transfer device (30, 40) of a system (1) for handling as claimed in one of claims 1 to 13, and **in that** it comprises a stage of transport and/or of performing at least one second operation on the watch components (2) arranged on the second support (20).
